# EUROPEAN PATENT SPECIFICATION

(11) **EP 4 024 093 B1**
(45) Date of publication and mention of the grant of the patent: **27.11.2024**
(21) Application number: 22150376.6
(22) Date of filing: 05.01.2022
(51) Int. Cl.: G02B 3/06, B23K 26/064, G02B 7/02, G02B 19/00

(54) **LASER CRYSTALLIZATION APPARATUS**
LASERKRISTALLISATIONSVORRICHTUNG
APPAREIL DE CRISTALLISATION AU LASER

(30) Priority: 05.01.2021 KR 20210000899
(43) Date of publication of application: 06.07.2022
(73) Proprietor: Samsung Display Co., Ltd., Yongin-si, Gyeonggi-do 17113 (KR)
(72) Inventor: SANGU, Akifumi, Hwaseong-si (KR); RYU, Je Kil, Suwon-si (KR); PARK, Cheol Ho, Suwon-si (KR); LEE, Hae Sook, Hwaseong-si (KR); JEUN, Jin Hong, Hwaseong-si (KR); CHAE, Young Su, Asan-si (KR); HAN, Gyoo Wan, Yongin-si (KR)
(74) Representative: Marks & Clerk LLP

(56) References cited:
- EP-A2- 1 076 359
- JP-A- 2013 105 943
- JP-A- H08 257 770
- KR-A- 20180 003 496

## Description

### BACKGROUND

### FIELD

Embodiments of the invention relate generally to a laser crystallization apparatus.

### DISCUSSION OF THE BACKGROUND

A liquid crystal display (LCD) and an organic light emitting diode (OLED) display, which are types of flat panel display devices, can be fabricated to be thin and light, so they are commonly used as a display device for mobile electronic devices, and their application coverage is being extended to large-scale display devices. In particular, as the necessity for a display device requiring high speed operational characteristics emerges, research for such a display device is actively ongoing.

In order to satisfy the high speed operational characteristics of a display device, a channel region of a thin film transistor (TFT) is formed by using polycrystalline silicon instead of amorphous silicon.

As a method of forming polycrystalline silicon, an annealing method using a laser has been disclosed.

Meanwhile, as a glass substrate for forming the display device is becoming larger, it is important to irradiate a laser beam over a wide area.

EP1076359 A2 discloses that in annealing a non-single crystal silicon film through the use of a linear laser beam emitted by a YAG laser of a light source, it is the object to prevent heterogeneity in energy caused by an optical interference produced in the linear laser beam from having an effect on the silicon film. The laser beam is divided by a mirror shaped like steps into laser beams which have an optical path difference larger than the coherence length of the laser beam between them. The divided laser beams are converged on an irradiate surface by the action of a cylindrical lens array and a cylindrical lens to homogenize the energy of the laser beam in the length direction and to determine the length of the linear laser beam. On the other hand, the laser beams divided by a cylindrical lens array are converged on the irradiate surface by a cylindrical lens and a doublet cylindrical lens to homogenize the energy in the width direction of the laser beam and to determine the width of the linear laser beam. Interference fringes parallel to the width direction of the linear laser beam disappear in the linear laser beam by the action of a mirror shaped like steps. If the silicon film is annealed by the linear laser beam while the linear laser beam is being shifted in the width direction of the linear laser beam, the silicon film is remarkably homogenized as compared with a conventional silicon film.

JP 2013 105943A discloses a plurality of laser emission surfaces arranged in the X and Y directions which are orthogonal to each other, and emit laser beams in the Z direction. A first cylindrical lens is arranged correspondingly along the line of the laser emission surfaces arranged in the X direction. The first cylindrical lens makes the laser beams emitted from the laser emission surfaces into a parallel ray bundle in the YZ plane. The plurality of laser beams having transmitted through the first cylindrical lens go into a second cylindrical lens. The second cylindrical lens overlaps the plurality of laser beams on a long region which is long in the X direction. The second cylindrical lens includes a plurality of optical members arranged in the X direction. Each of the optical members includes a column surface comprised of bus lines parallel to the X direction and a mirror polished end surface vertical to the X direction. The end surfaces of optical members neighboring each other closely contact with each other.

JP H08 257770A discloses that a light beam of an excimer laser is divided into multiple light beams for a small area so as to converge each light beam separately; the surface of an exposure mask is uniformly irradiated with each converging point used as an illuminating light source; the image of the illuminating light source is formed in the incident pupil of an image-forming lens, so that the image of the opening pattern of the exposure mask is formed, one to one, on the limited area of a work placed on the image-forming face of the image-forming lens and that the limited area is scanned over the entire area of the work. Thus, an ablation development is applied over the entire area of the work on which a pattern is developed and formed corresponding to the opening pattern of the exposure mask through the ablation phenomenon.

KR 2018 0003496A discloses a laser crystallization device and a laser crystallization method, which reduce occurrence of a profile abnormal part causing a display abnormal part when synthesizing a laser beam by using a plurality of light source parts. According to an embodiment, the laser crystallization device comprises: the plurality of light source parts; a plurality of lens arrays in which the laser beams generated from the plurality of light source parts are individually incident; and an optical system synthesizing each of the laser beams passing through the plurality of lens arrays. Each of the plurality of lens arrays includes a plurality of light dividing parts. A plurality of passing points through which each of center points of a plurality of laser beams passes through the plurality of light dividing parts have different positions which correspond to each of the light dividing parts.

The above information disclosed in this Background section is only for understanding of the background of the inventive concepts, and, therefore, it may contain information that does not constitute prior art.

### SUMMARY

An embodiment is to provide a laser crystallization apparatus capable of irradiating a laser beam to a large area without increasing a manufacturing cost.

Additional features of the inventive concepts will be set forth in the description which follows, and in part will be apparent from the description, or may be learned by practice of the inventive concepts.

A laser crystallization apparatus according to the invention is defined in claim 1.

Based on a direction perpendicular to the incident direction of the laser beam, a first length of the first portion and a second length of the second portion may be different from each other.

The first portion and the second portion may be bonded by optical contact bonding or welding.

The bonded surface may be parallel to the incident direction of the laser beam.

The bonded surface may be inclined to form a predetermined angle with the incident direction of the laser beam.

Based on a direction perpendicular to the incident direction of the laser beam, the width of the bonded surface may be about 0.3 % to about 0.6 % of a length of the optical unit.

The length of the optical unit may be about 2000 mm to about 2500 mm based on the direction perpendicular to the incident direction of the laser beam.

A laser crystallization apparatus according to another embodiment includes a light source unit configured to irradiate a laser beam; and an optical unit to which the laser beam is incident, in use, in an incident direction and including a plurality of sub-optical units, wherein each of the plurality of sub-optical units includes a first portion and a second portion bonded to each other to form a bonded surface, and the plurality of sub-optical units are sequentially arranged in a direction parallel to the incident direction of the laser beam.

The plurality of sub-optical units include at least a first sub-optical unit and a second sub-optical unit, and a length of the first portion of the first sub-optical unit is different from a length of the second portion of the second sub-optical unit.

The bonded surface of the first sub-optical unit and the bonded surface of the second sub-optical unit are disposed parallel to each other and offset from each other in a direction parallel to the incident direction of the laser beam.

Based on the direction parallel to the incident direction of the laser beam, the first width of the first portion and the second width of the second portion may be the same as each other at the bonded surface.

The bonded surface of the first sub-optical unit and the bonded surface of the second sub-optical unit may be parallel to the incident direction of the laser beam.

The bonded surface of the first sub-optical unit and the bonded surface of the second sub-optical unit may be inclined to form a predetermined angle with the incident direction of the laser beam.

Based on the direction perpendicular to the incident direction of the laser beam, a width of the bonded surface of the first sub-optical unit may be about 0.3 % to about 0.6 % of a length of the first sub-optical unit.

The length of the first sub-optical unit may be about 2000 mm to about 2500 mm.

The plurality of sub-optical units may be bonded along the incident direction of the laser beam.

The plurality of sub-optical units may be separated from each other along the incident direction of the laser beam.

A laser crystallization apparatus according to a related aspect includes a light source unit configured to irradiate a laser beam and an optical unit to which the laser beam is incident, in use, in an incident direction, the optical unit includes a first portion and a second portion bonded to each other to form a bonded surface, and the bonded surface is inclined to form a predetermined angle with the incident direction of the laser beam.

According to the laser crystallization apparatus according to the embodiments, the laser beam may be irradiated to a large-sized area without increasing a manufacturing cost.

The effects of the embodiments are not limited to the above-described effect, and the effects may be variously extended in a range that does not deviate from the scope of the embodiments.

It is to be understood that both the foregoing general description and the following detailed description are explanatory and are intended to provide further explanation of the invention as claimed.

At least some of the above and other features of the invention are set out in the claims.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the inventive concepts.
FIG. 1 is a schematic perspective view illustrating a laser crystallization apparatus according to an embodiment.
FIG. 2 is a view illustrating a part of a laser crystallization apparatus of FIG. 1.
FIG. 3 is a layout view illustrating a laser crystallization apparatus according to an embodiment.
FIG. 4 is a perspective view conceptually illustrating an optical unit of the laser crystallization apparatus of FIG. 3.
FIG. 5 is a view illustrating an example of an optical unit of a laser crystallization apparatus according to another embodiment.
FIG. 6 is an exploded perspective view of the optical unit of FIG. 5.
FIG. 7 is a graph conceptually illustrating changes in intensity of a laser beam passing through an optical unit of a laser crystallization apparatus according to an embodiment.
FIG. 8 is a view illustrating an example of an optical unit of a laser crystallization apparatus according to another embodiment.
FIG. 9 is a view illustrating an example of an optical unit of a laser crystallization apparatus according to another embodiment.
FIG. 10 is an exploded perspective view of the optical unit of FIG. 9.
FIG. 11 is a graph conceptually illustrating changes in intensity of a laser beam passing through an optical unit of a laser crystallization apparatus according to another embodiment.
FIG. 12 is a view illustrating an example of an optical unit of a laser crystallization apparatus according to another embodiment.

### DETAILED DESCRIPTION

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods employing one or more of the inventive concepts disclosed herein. It is apparent, however, that various embodiments may be practiced without these specific details or with one or more equivalent arrangements. In other instances, well-known structures and devices are illustrated in block diagram form in order to avoid unnecessarily obscuring various embodiments. Further, various embodiments may be different, but do not have to be exclusive. For example, specific shapes, configurations, and characteristics of an embodiment may be used or implemented in another embodiment without departing from the inventive concepts.

Unless otherwise specified, the illustrated embodiments are to be understood as providing features of varying detail of some ways in which the inventive concepts may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to a physical, electrical, and/or fluid connection, with or without intervening elements. Further, the dx-axis, the dy-axis, and the dz-axis are not limited to three axes of a rectangular coordinate system, such as the x, y, and z - axes, and may be interpreted in a broader sense. For example, the dx-axis, the dy-axis, and the dz-axis may be perpendicular to one another, or may represent different directions that are not perpendicular to one another. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of idealized embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Unless otherwise defined, all terms (including technical and scientific terms) used herein have the same meaning as commonly understood by one of ordinary skill in the art to which this disclosure is a part. Terms, such as those defined in commonly used dictionaries, should be interpreted as having a meaning that is consistent with their meaning in the context of the relevant art and should not be interpreted in an idealized or overly formal sense, unless expressly so defined herein.

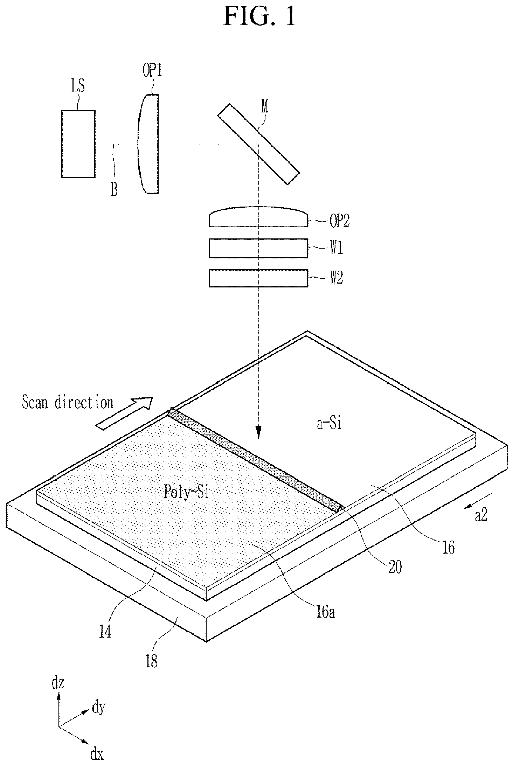

First, referring to FIG. 1, a laser crystallization apparatus according to the present embodiment includes a light source unit LS, a first optical unit OP1, a second optical unit M, a third optical unit OP2, a fourth optical unit W1 and a fifth optical unit W2.

According to a third direction dz, a substrate 14 including an amorphous silicon thin film 16 is disposed on a transporting stage 18, and a laser beam 20 of a line type generated from the laser crystallization apparatus according to the present embodiment is irradiated to the amorphous silicon thin film 16 in a direction parallel to the third direction dz. The laser beam 20 forms a line across the transporting stage 18 from one side to an opposite side such that the laser beam 20 may be scanned along a length of the amorphous silicon thin film 16 in a scan direction.

In this embodiment, the position of the laser beam 20 is fixed, and the transporting stage 18 may move in the transporting direction a2. That is, by the movement of the transporting stage 18, the laser beam 20 scans the amorphous silicon thin film 16 to be irradiated in the scan direction which is in an opposite direction to the transporting direction a2, and the amorphous silicon of the scanned region 16a may be converted into polycrystalline silicon through a solidification process following melting by the laser beam 20.

The laser beam 20 may have a line shape extending in the first direction (dx), and the crystallization operation that changes the amorphous silicon to the polycrystalline silicon may be uniformly done when the laser beam 20 of uniform intensity is irradiated along the first direction dx and caused to scan along the second direction dy.

The first optical unit OP1 may be a long-axis lens, the second optical unit M may be a mirror, the third optical unit OP2 may be a short-axis lens, and the fourth optical unit W1 and the fifth optical unit W2 may be windows. The long-axis lens and/or the short-axis lens may be a condenser lens or an image formation lens, but embodiments are not limited thereto. The first optical unit OP1, the second optical unit M, the third optical unit OP2, the fourth optical unit W1, and the fifth optical unit W2 are not limited thereto and may be different optical apparatuses.

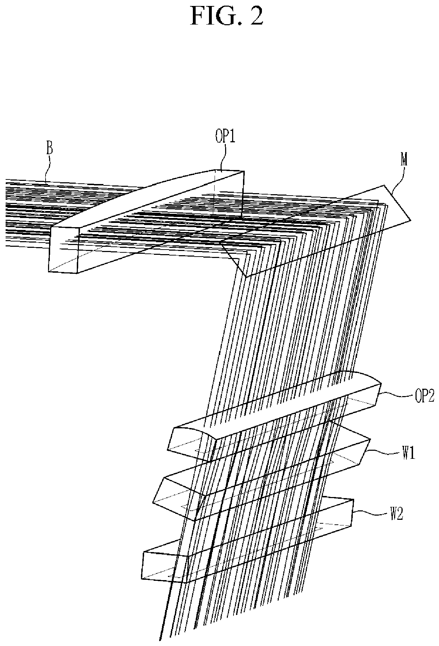

The laser beam B supplied from the light source unit LS passes through the first optical unit OP1 and is condensed in a long-axis direction, and passes through the third optical unit OP2 and is diffused in a short-axis direction after the path thereof is converted in the second optical unit M to be supplied as the laser beam 20 of the line shape through the fourth optical unit W1 and the fifth optical unit W2. As illustrated in FIG. 2, the laser beam B may include a plurality of collinear beams.

According to the laser crystallization apparatus according to the illustrated embodiment, the laser crystallization apparatus is described to include the first optical unit OP1, the second optical unit M, the third optical unit OP2, the fourth optical unit W1 and the fifth optical unit W2, however embodiments are not limited thereto. A plurality of different optical systems may be further included, and one or more of the first optical unit OP1, the second optical unit M, the third optical unit OP2, the fourth optical unit W1 and the fifth optical unit W2 may be omitted.

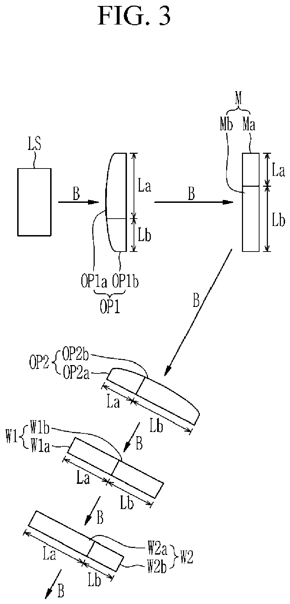

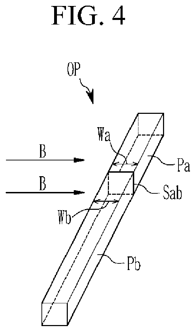

Next, the optical unit of the laser crystallization apparatus according to an embodiment is described in more detail with reference to FIG. 3 and FIG. 4. FIG. 3 is a layout view of a laser crystallization apparatus according to an embodiment, and FIG. 4 is a perspective view conceptually illustrating an optical unit of a laser crystallization apparatus of FIG. 3.

Referring to FIG. 3, the laser crystallization apparatus according to an embodiment includes the first optical unit OP1, the second optical unit M, the third optical unit OP2, the fourth optical unit W1, and the fifth optical unit W2 through which the laser beam B supplied from the light source unit LS passes.

In this embodiment, the first optical unit OP1 includes a first portion OP1a and a second portion OP1b. The first portion OP1a of the first optical unit OP1 and the second portion OP1b of the first optical unit OP1 are bonded to each other to form a bonded surface (which may also be described as a bonded part or bonded portion). The first portion OP1a of the first optical unit OP1 and the second portion OP1b of the first optical unit OP1 may be bonded to each other through optical contact bonding or welding.

A first length La of the first portion OP1a of the first optical unit OP1 and a second length Lb of the second portion OP1b of the first optical unit OP1 may be different from each other, but embodiments are not limited thereto. The first length La of the first portion OP1a of the first optical unit OP1 and the second length Lb of the second portion OP1b of the first optical unit OP1 may be the same as each other. Here, the first length La and the second length Lb are lengths measured based on a direction perpendicular to the direction in which the laser beam B is incident.

The sum La+Lb of the first length La of the first portion OP1a of the first optical unit OP1 and the second length Lb of the second portion OP1b of the first optical unit OP1 may be about 2000 mm to 2500 mm.

The bonded part of the first portion OP1a of the first optical unit OP1 and the second portion OP1b of the first optical unit OP1 may be parallel to the incidence direction of the laser beam B, at the bonded part of the first portion OP1a of the first optical unit OP1 and the second portion OP1b of the first optical unit OP1, and a width of the first portion OP1a of the first optical unit OP1 and a width of the second portion OP1b of the first optical unit OP1, which are measured in a direction parallel to the incident direction of the laser beam B, may be the same. Also, the widths of the first portion OP1a and second portion OP1b may vary as a surface of the first optical unit OP1 curves downward from a center to outward edges thereof.

Similarly, the second optical unit M includes a first portion Ma and a second portion Mb which are bonded to each other to form a bonded surface (which may also be described as a bonded part or bonded portion), and a first length La of the first portion Ma of the second optical unit M and a second length Lb of the second portion Mb of the second optical unit M may be different, but embodiments are not limited thereto. The first length La of the first portion Ma of the second optical unit M and the second length Lb of the second portion Mb of the second optical unit M may be the same as each other. The sum La+Lb of the first length La of the first portion Ma of the second optical unit M and the second length Lb of the second portion Mb of the second optical unit M may be about 2000 mm to 2500 mm. Here, the first length La and the second length Lb are lengths measured based on a direction perpendicular to the direction in which the laser beam B is incident.

In addition, the bonded part of the first portion Ma of the second optical unit M and the second portion Mb of the second optical unit M may be parallel to the incident direction of the laser beam B, at the bonded part of the first portion Ma of the second optical unit M and the second portion Mb of the second optical unit M. A width of the first portion Ma of the second optical unit M and the width of the second portion Mb of the second optical unit M, which are measured in the direction parallel to the incident direction of the laser beam B, may be the same.

Similarly, the third optical unit OP2 includes a first portion OP2a and a second portion OP2b bonded to each other to form a bonded surface (which may also be described as a bonded part or bonded portion), and a first length La of the first portion OP2a of the third optical unit OP2 and a second length Lb of the second portion OP2b of the third optical unit OP2 may be different, but embodiments are not limited thereto. The first length La of the first portion OP2a of the third optical unit OP2 and the second length Lb of the second portion OP2b of the third optical unit OP2 may be the same as each other. The sum La+Lb of the first length La of the first portion OP2a of the third optical unit OP2 and the second length Lb of the second portion OP2b of the third optical unit OP2 may be about 2000 mm to 2500 mm. Here, the first length La and the second length Lb are lengths measured based on a direction perpendicular to the direction in which the laser beam B is incident.

In addition, the bonded portion of the first portion OP2a of the third optical unit OP2 and the second portion OP2b of the third optical unit OP2 may be parallel to the incident direction of the laser beam B, at the bonded portion of the first portion OP2a of the third optical unit OP2 and the second portion OP2b of the third optical unit OP2, and a width of the first portion OP2a of the third optical unit OP2 and a width of the second portion OP2b of the third optical unit OP2, which are measured in the direction parallel to the incident direction of the laser beam B, may be the same as each other.

In addition, the fourth optical unit W1 includes a first portion W1a and a second portion W1b bonded to each other to form a bonded surface (which may also be described as a bonded part or bonded portion), and a first length La of the first portion W1a of the fourth optical unit W1 and a second length Lb of the second portion W1b of the fourth optical unit W1 may be different, but embodiments are not limited thereto. The first length La of the first portion W1a of the fourth optical unit W1 and the second length Lb of the second portion W1b of the fourth optical unit W1 may be the same as each other. The sum La+Lb of the first length La of the first portion W1a of the fourth optical unit W1 and the second length Lb of the second portion W1b of the fourth optical unit W1 may be about 2000 mm to 2500 mm. Here, the first length La and the second length Lb are lengths measured based on a direction perpendicular to the direction in which the laser beam B is incident.

In addition, the bonded portion of the first portion W1a of the fourth optical unit W1 and the second portion W1b of the fourth optical unit W1 may be parallel to the incident direction of the laser beam B, and at the bonded portion of the first portion W1a of the fourth optical unit W1 and the second portion W1b of the fourth optical unit W1, a width of the first portion W1a of the fourth optical unit W1 and a width of the second portion W1b of the fourth optical unit W1, which are measured in the direction parallel to the incident direction of the laser beam B, may be the same as each other.

Similarly, the fifth optical unit W2 includes a first portion W2a and a second portion W2b bonded to each other to form a bonded surface (which may also be described as a bonded part or bonded portion), and a first length La of the first portion W2a of the fifth optical unit W2 and a second length Lb of the second portion W2b of the fifth optical unit W2 may be different, but embodiments are not limited thereto. The first length La of the first portion W2a of the fifth optical unit W2 and the second length Lb of the second portion W2b of the fifth optical unit W2 may be the same as each other. The sum La+Lb of the first length La of the first portion W2a of the fifth optical unit W2 and the second length Lb of the second portion W2b of the fifth optical unit W2 may be about 2000 mm to 2500 mm. Here, the first length La and the second length Lb are lengths measured based on a direction perpendicular to the direction in which the laser beam B is incident.

Also, the bonded portion of the first portion W2a of the fifth optical unit W2 and the second portion W2b of the fifth optical unit W2 may be parallel to the incident direction of the laser beam B, and at the bonded portion of the first portion W2a of the fifth optical unit W2 and the second portion W2b of the fifth optical unit W2, a width of the first portion W2a of the fifth optical unit W2 and a width of the second portion W2b of the fifth optical unit W2, which are measured in a direction parallel to the incident direction of the laser beam B, may be the same as each other.

The first length La of the first portion OP1a of the first optical unit OP1 may be different from or may be the same as the first length La of the first portion Ma of the second optical unit M. In addition, the second length Lb of the second portion OP1b of the first optical unit OP1 may be different from or may be the same as the second length Lb of the second portion Mb of the second optical unit M.

The first length La of the first portion Ma of the second optical unit M may be different from or may be the same as the first length La of the first portion OP2a of the third optical unit OP2. In addition, the second length Lb of the second portion Mb of the second optical unit M may be different from or may be the same as the second length Lb of the second portion OP2b of the third optical unit OP2.

The first length La of the first portion OP2a of the third optical unit OP2 may be different from or may be the same as the first length La of the first portion W1a of the fourth optical unit W1. In addition, the second length Lb of the second portion OP2b of the third optical unit OP2 may be different from or may be the same as the second length Lb of the second portion W1b of the fourth optical unit W 1.

The first length La of the first portion W1a of the fourth optical unit W1 may be different from or may be the same as the first length La of the first portion W2a of the fifth optical unit W2.

In addition, the second length Lb of the second portion W1b of the fourth optical unit W1 may be different from or may be the same as the second length Lb of the second portion W2b of the fifth optical unit W2.

The first length La of the first portion W2a of the fifth optical unit W2 may be different from or may be the same as the first length La of the first portion OP1a of the first optical unit OP1. In addition, the second length Lb of the second portion W2b of the fifth optical unit W2 may be different from or may be the same as the second length Lb of the second portion OP1b of the first optical unit OP1.

According to the embodiment of FIG. 3, it is described that each of the optical units OP1, M, OP2, W1, and W2 of the laser crystallization apparatus includes the first portion and the second portion bonded to each other, however it is not limited thereto, and at least one of the optical units OP1, M, OP2, W1, and W2 of the laser crystallization apparatus may include the first portion and the second portion bonded to each other.

Now, the structure of the optical units OP1, M, OP2, W1, and W2 of the laser crystallization apparatus according to a third embodiment is described in more detail with reference to FIG. 4.

The optical units OP1, M, OP2, W1, and W2 of the laser crystallization apparatus according to the embodiment of FIG. 3 may have the same structure as the optical unit OP illustrated in FIG. 4.

Referring to FIG. 4, the optical unit OP of the laser crystallization apparatus according to the embodiment includes a first portion Pa and a second portion Pb bonded to each other to form a bonded surface (which may also be described as a bonded part or bonded portion). The first portion Pa and the second portion Pb of the optical unit OP may include or comprise glass.

The first portion Pa and the second portion Pb of the optical unit OP may be bonded to each other at a boundary between the first portion Pa and the second portion Pb through a bonding element such as optical contact bonding or welding. A bonded surface Sab of the first portion Pa and the second portion Pb of the optical unit OP may be parallel to the incident direction of the laser beam B.

The bonded surface Sab at the boundary between the first portion Pa and the second portion Pb includes a material layer combination that includes a part (e.g. a respective bonded surface) of the first portion Pa adjacent the boundary, the bonding element, and a part (e.g. a respective bonded surface) of the second portion Pb adjacent the boundary. The bonded surface Sab may have a thickness as described herein.

In the bonded surface Sab of the first portion Pa and the second portion Pb of the optical unit OP, a first width Wa of the first portion Pa and a second width Wb of the second portion Pb measured in a direction parallel to the incident direction of the laser beam B may be the same.

As a glass substrate for forming a display device becomes larger, the laser crystallization apparatus may irradiate a laser beam over a wide area, and for this purpose, the size of the optical unit of the laser crystallization apparatus may be increased. When forming the optical unit having a large size using a single piece of glass, a manufacturing cost increases.

The laser crystallization apparatus according to the embodiment includes the optical unit including the first portion and the second portion bonded to each other, and the bonded portions of the first portion and the second portion may be bonded to each other through optical contact bonding or the welding. Accordingly, using bonded surfaces to join a plurality of smaller parts instead of requiring larger monolithic parts, it is possible to more easily diversify a shape and/or size of the optical units so as to form the laser crystallization apparatus including the optical units having large sizes without increasing the manufacturing cost of the laser crystallization apparatus.

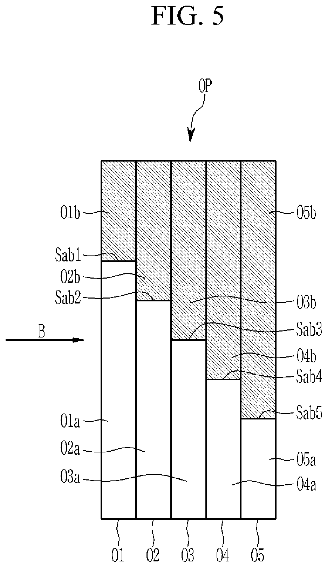

Next, the laser crystallization apparatus according to another embodiment is described with reference to FIG. 5. FIG. 5 is a view illustrating an example of an optical unit of a laser crystallization apparatus according to an embodiment.

As described herein, the laser crystallization apparatus according to the present embodiment includes a plurality of optical units OP1, M, OP2, W1, and W2, and at least one among a plurality of optical units OP1, M, OP2, W1, and W2 of the laser crystallization apparatus may have a structure of the optical unit OP illustrated in FIG. 5.

Referring to FIG. 5, the optical unit OP of the laser crystallization apparatus according to the present embodiment may include a plurality of sub-optical units O1, O2, O3, O4, and O5.

The first sub-optical unit O1, the second sub-optical unit O2, the third sub-optical unit O3, the fourth sub-optical unit O4, and the fifth sub-optical unit O5 of the optical unit OP may be connected to each other.

The first sub-optical unit O1 of the optical unit OP may include a first portion O1a and a second portion O1b bonded to each other, the second sub-optical unit O2 of the optical unit OP may include a third portion O2a and a fourth portion O2b bonded to each other, the third sub-optical unit O3 of the optical unit OP may include a fifth portion O3a and a sixth portion O3b bonded to each other, the fourth sub-optical unit O4 of the optical unit OP may include a seventh portion O4a and an eighth portion O4b bonded to each other, the fifth sub-optical unit O5 of the optical unit OP may include a ninth portion O5a and a tenth portion O5b bonded to each other.

The first portion O1a and the second portion O1b of the first sub-optical unit O1 of the optical unit OP are bonded to each other to form a first bonded surface Sab1, the third portion O2a and the fourth portion O2b of the second sub-optical unit O2 of the optical unit OP are bonded to each other to form a second bonded surface Sab2, the fifth portion O3a and the sixth portion O3b of the third sub-optical unit O3 of the optical unit OP are bonded to each other to form a third bonded surface Sab3, the seventh portion O4a and the eighth portion O4b of the fourth sub-optical unit O4 of the optical unit OP are bonded to each other to form a fourth bonded surface Sab4, and the ninth portion O5a and the tenth portion O5b of the fifth sub-optical unit O5 of the optical unit OP are bonded to each other to form a fifth bonded surface Sab5.

The first bonded surface Sab1 of the first sub-optical unit O1 of the optical unit OP, the second bonded surface Sab2 of the second sub-optical unit O2 of the optical unit OP, the third bonded surface Sab3 of the third sub-optical unit O3 of the optical unit OP, the fourth bonded surface Sab4 of the fourth sub-optical unit O4 of the optical unit OP, and the fifth bonded surface Sab5 of the fifth sub-optical unit O5 of the optical unit OP may be parallel to the incident direction of the laser beam B on the optical unit OP. Also, based on the direction parallel to the incident direction of the laser beam B incident to the optical unit OP, the first bonded surface Sab1 of the first sub-optical unit O1 of the optical unit OP, the second bonded surface Sab2 of the second sub-optical unit O2 of the optical unit OP, the third bonded surface Sab3 of the third sub-optical unit O3 of the optical unit OP, the fourth bonded surface Sab4 of the fourth sub-optical unit O4 of the optical unit OP, and the fifth bonded surface Sab5 of the fifth sub-optical unit O5 of the optical unit OP are not disposed in line with each other, but may be disposed to be offset from each other in a direction perpendicular to the incident direction of the laser beam B.

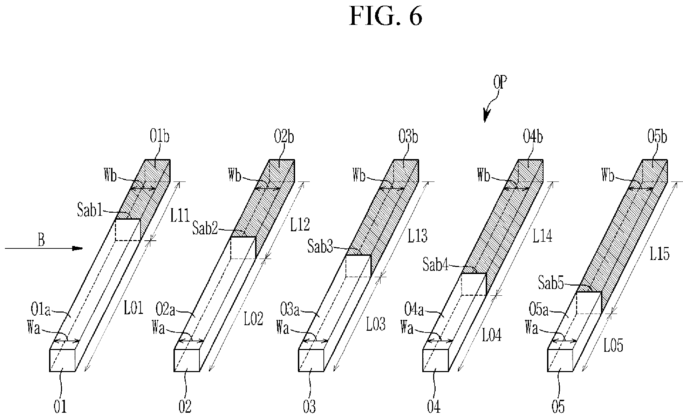

Now, the sub-optical units of the optical unit of FIG. 5 are described in more detail with reference to FIG. 6 along with FIG. 5. FIG. 6 is an exploded perspective view of the optical unit of FIG. 5.

Referring to FIG. 6 along with FIG. 5, the optical unit OP of the laser crystallization apparatus according to the present embodiment includes a plurality of sub-optical units O1, O2, O3, O4, and O5.

The first sub-optical unit O1 of the optical unit OP includes a first portion O1a and a second portion O1b bonded to each other on the first bonded surface Sab1, and a first length L01 of the first portion O1a of the first sub-optical unit O1 of the optical unit OP and a second length L11 of the second portion O1b of the first sub-optical unit O1 of the optical unit OP may be different from each other or may be the same.

The first bonded surface Sab1 of the first sub-optical unit O1 of the optical unit OP may be a surface approximately parallel to the incident direction of the laser beam B. Based on the direction parallel to the incident direction of the laser beam B, a first width Wa of the first portion O1a of the first sub-optical unit O1 and a second width Wb of the second portion O1b of the first sub-optical unit O1 may be the same as each other on the first bonded surface Sab1.

The second sub-optical unit O2 of the optical unit OP includes a third portion O2a and a fourth portion O2b bonded to each other on the second bonded surface Sab2, and a third length L02 of the third portion O2a of the second sub-optical unit O2 of the optical unit OP and a fourth length L12 of the fourth portion O2b of the second sub-optical unit O2 of the optical unit OP may be different from or the same as each other.

The second bonded surface Sab2 of the second sub-optical unit O2 of the optical unit OP may be a surface approximately parallel to the incident direction of the laser beam B. Based on the direction parallel to the incident direction of the laser beam B, a first width Wa of the third portion O2a of the second sub-optical unit O2 and a second width Wb of the fourth portion O2b of the second sub-optical unit O2 may be the same as each other on the second bonded surface Sab2.

The third sub-optical unit O3 of the optical unit OP may include a fifth portion O3a and the sixth portion O3b bonded to each other on the third bonded surface Sab3, and a fifth length L03 of the fifth portion O3a of the third sub-optical unit O3 of the optical unit OP and a sixth length L13 of the sixth portion O3b of the third sub-optical unit O3 of the optical unit OP may be different from or the same as each other.

The third bonded surface Sab3 of the third sub-optical unit O3 of the optical unit OP may be a surface approximately parallel to the incident direction of the laser beam B. Based on the direction parallel to the incident direction of the laser beam B, a first width Wa of the fifth portion O3a of the third sub-optical unit O3 and tahe second width Wb of the sixth portion O3b of the third sub-optical unit O3 may be the same as each other on the third bonded surface Sab3.

The fourth sub-optical unit O4 of the optical unit OP includes a seventh portion O4a and an eighth portion O4b bonded to each other on the fourth bonded surface Sab4, and a seventh length L04 of the seventh portion O4a of the fourth sub-optical unit O4 of the optical unit OP and an eighth length L14 of the eighth portion O4b of the fourth sub-optical unit O4 of the optical unit OP may be different from or the same as each other.

The fourth bonded surface Sab4 of the fourth sub-optical unit O4 of the optical unit OP may be a surface approximately parallel to the incident direction of the laser beam B. Based on the direction parallel to the incident direction of the laser beam B, a first width Wa of the seventh portion O4a of the fourth sub-optical unit O4 and a second width Wb of the eighth portion O4b of the fourth sub-optical unit O4 may be the same as each other on the fourth bonded surface Sab4.

The fifth sub-optical unit O5 of the optical unit OP may include a ninth portion O5a and a tenth portion O5b bonded to each other on the fifth bonded surface Sab5, and a ninth length L05 of the ninth portion O5a of the fifth sub-optical unit O5 of the optical unit OP and a tenth length L15 of the tenth portion O5b of the fifth sub-optical unit O5 of the optical unit OP may be different from or the same as each other.

The fifth bonded surface Sab5 of the fifth sub-optical unit O5 of the optical unit OP may be a surface approximately parallel to the incident direction of the laser beam B. Based on the direction parallel to the incident direction of the laser beam B, a first width Wa of the ninth portion O5a of the fifth sub-optical unit O5 and a second width Wb of the tenth portion O5b of the fifth sub-optical unit O5 may be the same as each other on the fifth bonded surface Sab5.

The first length L01 of the first portion O1a of the first sub-optical unit O1 of the optical unit OP, the third length L02 of the third portion O2a of the second sub-optical unit O2 of the optical unit OP, the fifth length L03 of the fifth portion O3a of the third sub-optical unit O3 of the optical unit OP, the seventh length L04 of the seventh portion O4a of the fourth sub-optical unit O4 of the optical unit OP, and the ninth length L05 of the ninth portion O5a of the fifth sub-optical unit O5 of the optical unit OP may be different from each other. Here, the first length L01, the third length L02, the fifth length L03, the seventh length L04, and the ninth length L05 may be lengths measured in the direction perpendicular to the incident direction of the laser beam B.

Similarly, the second length L11 of the second portion O1b of the first sub-optical unit O1 of the optical unit OP, the fourth length L12 of the fourth portion O2b of the second sub-optical unit O2 of the optical unit OP, the sixth length L13 of the sixth portion O3b of the third sub-optical unit O3 of the optical unit OP, the eighth length L14 of the eighth portion O4b of the fourth sub-optical unit O4 of the optical unit OP, and the tenth length L15 of the tenth portion O5b of the fifth sub-optical unit O5 of the optical unit OP may be different from each other. Here, the second length L11, the fourth length L12, the sixth length L13, the eighth length L14, and the tenth length L15 may be lengths measured in the direction perpendicular to the incident direction of the laser beam B.

The first portion O1a and the second portion O1b of the first sub-optical unit O1 of the optical unit OP may be bonded to each other through optical contact bonding or welding, the third portion O2a and the fourth portion O2b of the second sub-optical unit O2 of the optical unit OP may be bonded to each other through optical contact bonding or welding, the fifth portion O3a and the sixth portion O3b of the third sub-optical unit O3 of the optical unit OP may be bonded to each other through optical contact bonding or welding, the seventh portion O4a and the eighth portion O4b of the fourth sub-optical unit O4 of the optical unit OP may be bonded to each other through optical contact bonding or welding, and the ninth portion O5a and the tenth portion O5b of the fifth sub-optical unit O5 of the optical unit OP may be bonded to each other through optical contact bonding or welding.

Also, the first sub-optical unit O1, the second sub-optical unit O2, the third sub-optical unit O3, the fourth sub-optical unit O4, and the fifth sub-optical unit O5 of the optical unit OP may be sequentially disposed along the direction parallel to the incident direction of the laser beam B, and the first sub-optical unit O1, the second sub-optical unit O2, the third sub-optical unit O3, the fourth sub-optical unit O4, and the fifth sub-optical unit O5 of the optical unit OP may be bonded to each other through optical contact bonding or welding.

Based on the direction parallel to the incident direction of the laser beam B on the optical unit OP, the first bonded surface Sab1 of the first sub-optical unit O1 of the optical unit OP, the second bonded surface Sab2 of the second sub-optical unit O2 of the optical unit OP, the third bonded surface Sab3 of the third sub-optical unit O3 of the optical unit OP, the fourth bonded surface Sab4 of the fourth sub-optical unit O4 of the optical unit OP, and the fifth bonded surface Sab5 of the fifth sub-optical unit O5 of the optical unit OP are not disposed in a line with each other, but may be disposed to be offset from each other in a direction perpendicular to the incident direction of the laser beam B.

According to the embodiment illustrated in FIG. 5 and FIG. 6 above, it is described that the optical unit of the laser crystallization apparatus according to the embodiment includes five sub-optical units O1, O2, O3, O4, and O5, however it is not limited thereto, and the number of the plurality of sub-optical units may be changed.

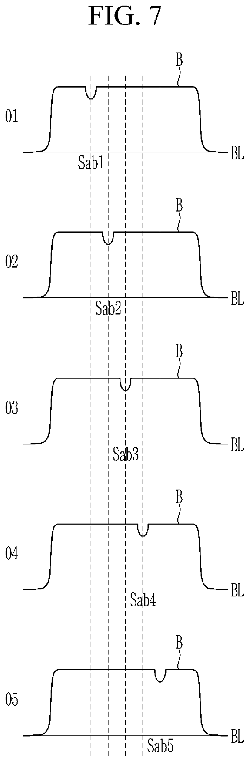

A change in intensity of a laser beam passing through the optical unit of the laser crystallization apparatus according to an embodiment is described with reference to FIG. 7 along with FIG. 5 and FIG. 6. FIG. 7 is a graph conceptually illustrating changes in intensity of a laser beam passing through an optical unit of a laser crystallization apparatus according to an embodiment.

Referring to FIG. 7 along with FIG. 5 and FIG. 6, while the laser beam B passes through the first sub-optical unit O1, the second sub-optical unit O2, the third sub-optical unit O3, the fourth sub-optical unit O4, and the fifth sub-optical unit O5 of the optical unit OP, the intensity BL of the laser beam B may be reduced on the first bonded surface Sab1 of the first sub-optical unit O1 of the optical unit OP, the second bonded surface Sab2 of the second sub-optical unit O2 of the optical unit OP, the third bonded surface Sab3 of the third sub-optical unit O3 of the optical unit OP, the fourth bonded surface Sab4 of the fourth sub-optical unit O4 of the optical unit OP, and the fifth bonded surface Sab5 of the fifth sub-optical unit O5 of the optical unit OP.

As described herein with reference to FIG. 5 and FIG. 6, based on the direction parallel to the incident direction of the laser beam B incident to the optical unit OP of the laser crystallization apparatus according to the embodiment, because the first bonded surface Sab1 of the first sub-optical unit O1 of the optical unit OP, the second bonded surface Sab2 of the second sub-optical unit O2 of the optical unit OP, the third bonded surface Sab3 of the third sub-optical unit O3 of the optical unit OP, the fourth bonded surface Sab4 of the fourth sub-optical unit O4 of the optical unit OP, and the fifth bonded surface Sab5 of the fifth sub-optical unit O5 of the optical unit OP are not disposed in line with each other, but are disposed to be offset from each other, the first bonded surface Sab1, the second bonded surface Sab2, the third bonded surface Sab3, the fourth bonded surface Sab4, and the fifth bonded surface Sab5, in which the intensity BL of the laser beam B is changed, do not overlap each other.

Accordingly, the change of the intensity BL of the laser beam B passing through the optical unit OP is not concentrated at a specific position, and therefore by spacing the bonded surfaces evenly about the width of the laser beam B, the intensity of a uniform laser beam B may be supplied evenly to the substrate 14 according to the positions of the bonded surfaces.

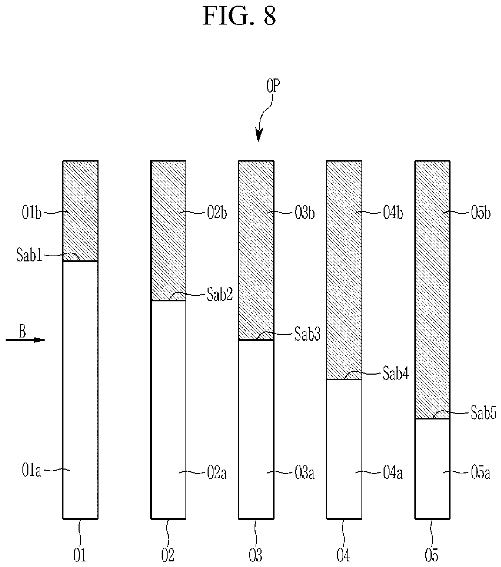

Next, the laser crystallization apparatus according to another embodiment is described with reference to FIG. 8. FIG. 8 is a view illustrating one example of an optical unit of a laser crystallization apparatus according to another embodiment.

As described herein, the laser crystallization apparatus according to embodiments includes a plurality of optical units OP1, M, OP2, W1, and W2, and at least one among the plurality of optical units OP1, M, OP2, W1, and W2 of the laser crystallization apparatus may have the structure of the optical unit OP illustrated in FIG. 8.

Referring to FIG. 8, the optical unit OP of the laser crystallization apparatus according to the present embodiment may include a plurality of sub-optical units O1, O2, O3, O4, and O5 separated from each other.

The first sub-optical unit O1 of the optical unit OP may include a first portion O1a and a second portion O1b bonded to each other, the second sub-optical unit O2 of the optical unit OP may include a third portion O2a and a fourth portion O2b bonded to each other, the third sub-optical unit O3 of the optical unit OP may include a fifth portion O3a and a sixth portion O3b bonded to each other, the fourth sub-optical unit O4 of the optical unit OP may include a seventh portion O4a and an eighth portion O4b bonded to each other, and the fifth sub-optical unit O5 of the optical unit OP may include a ninth portion O5a and a tenth portion O5b bonded to each other.

The first portion O1a and the second portion O1b of the first sub-optical unit O1 of the optical unit OP are bonded to each other on the first bonded surface Sab1, the third portion O2a and the fourth portion O2b of the second sub-optical unit O2 of the optical unit OP are bonded to each other on the second bonded surface Sab2, the fifth portion O3a and the sixth portion O3b of the third sub-optical unit O3 of the optical unit OP are bonded to each other on the third bonded surface Sab3, the seventh portion O4a and the eighth portion O4b of the fourth sub-optical unit O4 of the optical unit OP are bonded to each other on the fourth bonded surface Sab4, and the ninth portion O5a and the tenth portion O5b of the fifth sub-optical unit O5 of the optical unit OP are bonded to each other on the fifth bonded surface Sab5.

The first bonded surface Sab1 of the first sub-optical unit O1 of the optical unit OP, the second bonded surface Sab2 of the second sub-optical unit O2 of the optical unit OP, the third bonded surface Sab3 of the third sub-optical unit O3 of the optical unit OP, the fourth bonded surface Sab4 of the fourth sub-optical unit O4 of the optical unit OP, and the fifth bonded surface Sab5 of the fifth sub-optical unit O5 of the optical unit OP may be respectively parallel to the incident direction of the laser beam B incident to the optical unit OP. Also, based on the direction parallel to the incident direction of the laser beam B incident to the optical unit OP, the first bonded surface Sab1 of the first sub-optical unit O1 of the optical unit OP, the second bonded surface Sab2 of the second sub-optical unit O2 of the optical unit OP, the third bonded surface Sab3 of the third sub-optical unit O3 of the optical unit OP, the fourth bonded surface Sab4 of the fourth sub-optical unit O4 of the optical unit OP, and the fifth bonded surface Sab5 of the fifth sub-optical unit O5 of the optical unit OP are not disposed in a line with each other, but may be disposed to be offset from each other in a direction perpendicular to the emission of the laser beam B.

According to the embodiment illustrated in FIG. 8, it is described that the optical unit of the laser crystallization apparatus according to an embodiment includes the five sub-optical units O1, O2, O3, O4, and O5, however it is not limited thereto, and the number of the plurality of sub-optical units may be changed.

Many characteristics of the optical units of the laser crystallization apparatuses according to the embodiments described with reference to FIG. 1 to FIG. 7 above may be applied to the optical unit of the laser crystallization apparatus according to the present embodiment.

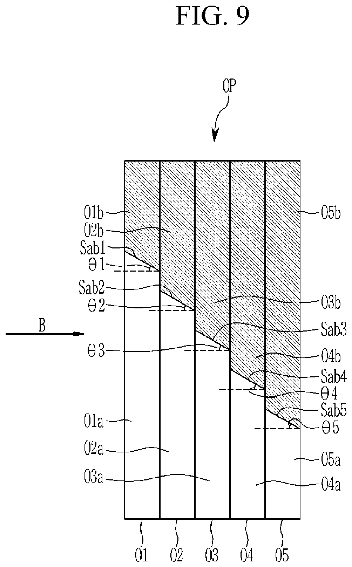

Next, the laser crystallization apparatus according to another embodiment is described with reference to FIG. 9. FIG. 9 is a view illustrating one example of an optical unit of a laser crystallization apparatus according to another embodiment.

As described herein, the laser crystallization apparatus according to embodiments includes a plurality of optical units OP1, M, OP2, W1, and W2, and at least one among the plurality of optical units OP1, M, OP2, W1, and W2 of the laser crystallization apparatus may have the structure of the optical unit OP illustrated in FIG. 9.

Referring to FIG. 9, the optical unit OP of the laser crystallization apparatus according to the present embodiment may include a plurality of sub-optical units O1, O2, O3, O4, and O5.

The first sub-optical unit O1, the second sub-optical unit O2, the third sub-optical unit O3, the fourth sub-optical unit O4, and the fifth sub-optical unit O5 may be sequentially disposed according to the direction parallel to the incident direction of the laser beam B of the optical unit OP.

The first sub-optical unit O1 of the optical unit OP may include a first portion O1a and a second portion O1b bonded to each other, the second sub-optical unit O2 of the optical unit OP may include a third portion O2a and a fourth portion O2b bonded to each other, the third sub-optical unit O3 of the optical unit OP may include a fifth portion O3a and a sixth portion O3b bonded to each other, the fourth sub-optical unit O4 of the optical unit OP may include a seventh portion O4a and an eighth portion O4b bonded to each other, and the fifth sub-optical unit O5 of the optical unit OP may include a ninth portion O5a and a tenth portion O5b bonded to each other.

The first portion O1a and the second portion O1b of the first sub-optical unit O1 of the optical unit OP are bonded to each other on the first bonded surface Sab1, the third portion O2a and the fourth portion O2b of the second sub-optical unit O2 of the optical unit OP are bonded to each other on the second bonded surface Sab2, the fifth portion O3a and the sixth portion O3b of the third sub-optical unit O3 of the optical unit OP are bonded to each other on the third bonded surface Sab3, the seventh portion O4a and the eighth portion O4b of the fourth sub-optical unit O4 of the optical unit OP are bonded to each other on the fourth bonded surface Sab4, and the ninth portion O5a and the tenth portion O5b of the fifth sub-optical unit O5 of the optical unit OP are bonded to each other on the fifth bonded surface Sab5.

The bonded surfaces Sab at the boundaries between the respective portions include a material composition including a part of a first portion adjacent the boundary, the bonding element, and a part of a second portion adjacent the boundary extending perpendicular to the incident direction of the laser beam B.

The first bonded surface Sab1 of the first sub-optical unit O1 of the optical unit OP may form a first angle θ1 with the incident direction of the laser beam B, the second bonded surface Sab2 of the second sub-optical unit O2 of the optical unit OP may form a second angle θ2 with the incident direction of the laser beam B, the third bonded surface Sab3 of the third sub-optical unit O3 of the optical unit OP may form a third angle θ3 with the incident direction of the laser beam B, the fourth bonded surface Sab4 of the fourth sub-optical unit O4 of the optical unit OP may form a fourth angle θ4 with the incident direction of the laser beam B, and the fifth bonded surface Sab5 of the fifth sub-optical unit O5 of the optical unit OP may form a fifth angle θ5 with the incident direction of the laser beam B.

The first angle θ1, the second angle θ2, the third angle θ3, the fourth angle θ4, and the fifth angle θ5 may be smaller than about 45 degrees, and may be equal to or different from each other.

Also, based on the direction parallel to the incident direction of the laser beam B incident to the optical unit OP, the first bonded surface Sab1 of the first sub-optical unit O1 of the optical unit OP, the second bonded surface Sab2 of the second sub-optical unit O2 of the optical unit OP, the third bonded surface Sab3 of the third sub-optical unit O3 of the optical unit OP, the fourth bonded surface Sab4 of the fourth sub-optical unit O4 of the optical unit OP, and the fifth bonded surface Sab5 of the fifth sub-optical unit O5 of the optical unit OP are not disposed in a line with each other, but may be disposed to be offset from each other in a direction perpendicular to the incident direction of the laser beam B.

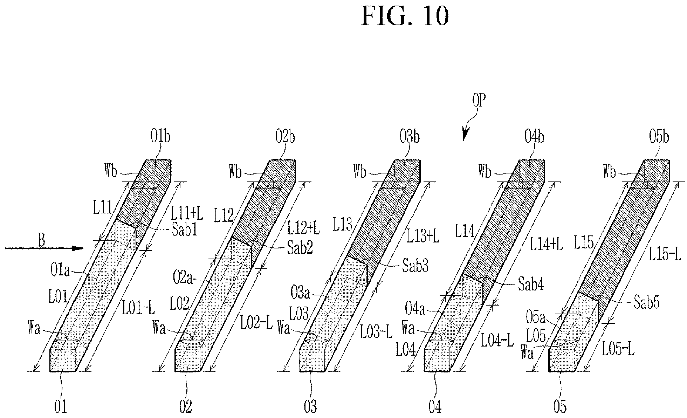

Next, the sub-optical units of the optical unit of FIG. 9 are described in detail with reference to FIG. 10 along with FIG. 9. FIG. 10 is an exploded perspective view of the optical unit of FIG. 9.

Referring to FIG. 10 along with FIG. 9, the optical unit OP of the laser crystallization apparatus according to the present embodiment includes a plurality of sub-optical units O1, O2, O3, O4, and O5.

The first sub-optical unit O1 of the optical unit OP includes the first portion O1a and the second portion O1b bonded to each other on the first bonded surface Sab1, and a first length L01 of a first surface of the first portion O1a of the first sub-optical unit O1 and a second length L11 of a first surface of the second portion O1b may be different, respectively, from a first length (L01-L) of a second surface opposite to the first surface of the first portion O1a of the first sub-optical unit O1 and a second length (L11+L) of a second surface opposite to the first surface of the second portion O1b of the first sub-optical unit O1.

In detail, the first length L01-L of the second surface of the first portion O1a of the first sub-optical unit O1 may be shorter by a length difference L than the first length L01 of the first surface of the first portion O1a of the first sub-optical unit O1. The second length L11+L of the second surface of the second portion O1b of the first sub-optical unit O1 may be longer by the length difference L than the second length L11 of the first surface of the second portion O1b of the first sub-optical unit O1. That is, based on the direction perpendicular to the incident direction of the laser beam B, the width of the first bonded surface Sab1 of the first sub-optical unit O1 may be the same as the length difference L.

The length difference L and the width of the first bonded surface Sab1 may be about 0.3 % to about 0.6 % of an entire length of the first sub-optical unit O1. For example, the entire length of the first sub-optical unit O1 may be about 2200 mm, and the length difference L and the width of the first bonded surface Sab1 may be about 10 mm.

The width of the first bonded surface Sab1 refers to a combined width including part of the first portion O1a, part of the second portion O1b, and a bonding element area at the boundary of the first portion O1a and the second portion O1b. This composition is representative of the other bonded surfaces discussed herein.

As described herein, lengths are measured in the direction perpendicular to the incident direction of the laser beam B.

Also, the first bonded surface Sab1 of the first sub-optical unit O1 of the optical unit OP may form the first angle θ1 with the incident direction of the laser beam B, and based on the direction parallel to the incident direction of the laser beam B, the first width Wa of the first portion O1a of the first sub-optical unit O1 and the second width Wb of the second portion O1b of the first sub-optical unit O1 may be the same as each other on the first bonded surface Sab1.

Similarly, the second sub-optical unit O2 of the optical unit OP includes the third portion O2a and the fourth portion O2b bonded to each other on the second bonded surface Sab2, and a third length L02 of a first surface of the third portion O2a of the second sub-optical unit O2 and a fourth length L12 of a first surface of the fourth portion O2b of the second sub-optical unit O2 may be different, respectively, from a third length L02-L of a second surface of the third portion O2a of the second sub-optical unit O2 and a fourth length L12+L of a second surface of the fourth portion O2b of the second sub-optical unit O2 by the length difference L. That is, based on the direction perpendicular to the incident direction of the laser beam B, on the second sub-optical unit O2, a width of the second bonded surface Sab2 may be the same as the length difference L.

The length difference L and the width of the second bonded surface Sab2 may be about 0.3 % to about 0.6 % of an entire length of the second sub-optical unit O2. For example, when the entire length of the second sub-optical unit O2 is about 2200 mm, the length difference L and the width of the second bonded surface Sab2 may be about 10 mm.

The above-described lengths are the lengths measured in the direction perpendicular to the incident direction of the laser beam B.

Also, the second bonded surface Sab2 of the second sub-optical unit O2 of the optical unit OP may form the second angle θ2 with the incident direction of the laser beam B, and based on the direction parallel to the incident direction of the laser beam B, a first width Wa of the third portion O2a of the second sub-optical unit O2 and a second width Wb of the fourth portion O2b of the second sub-optical unit O2 may be the same as each other on the second bonded surface Sab2.

The third sub-optical unit O3 of the optical unit OP includes the fifth portion O3a and the sixth portion O3b bonded to each other on the third bonded surface Sab3, and a fifth length L03 of a first surface of the fifth portion O3a of the third sub-optical unit O3 and a sixth length L13 of a first surface of the sixth portion O3b of the third sub-optical unit O3 may be different, respectively, from a fifth length L03-L of a second surface of the fifth portion O3a of the third sub-optical unit O3 and a sixth length L13+L of a second surface of the sixth portion O3b of the third sub-optical unit O3 by the length difference L. That is, based on the direction perpendicular to the incident direction of the laser beam B, on the third sub-optical unit O3, a width of the third bonded surface Sab3 may be the same as the length difference L.

The length difference L and the width of the third bonded surface Sab3 may be about 0.3 % to about 0.6 % of the entire length of the third sub-optical unit O3. For example, when the entire length of the third sub-optical unit O3 is about 2200 mm, the length difference L and the width of the third bonded surface Sab3 may be about 10 mm.

All lengths described above are lengths measured in the direction perpendicular to the direction in which the laser beam B is incident.

Also, the third bonded surface Sab3 of the third sub-optical unit O3 of the optical unit OP may form the third angle θ3 with the incident direction of the laser beam B, and based on the direction parallel to the incident direction of the laser beam B, a first width Wa of the fifth portion O3a of the third sub-optical unit O3 and a second width Wb of the sixth portion O3b of the third sub-optical unit O3 may be the same as each other on the third bonded surface Sab3.

The fourth sub-optical unit O4 of the optical unit OP includes the seventh portion O4a and the eighth portion O4b bonded to each other on the fourth bonded surface Sab4, and a seventh length L04 of a first surface of the seventh portion O4a of the fourth sub-optical unit O4 and an eighth length L 14 of a first surface of the eighth portion O4b of the fourth sub-optical unit O4 may be different, respectively, from a seventh length L04-L of a second surface seventh portion O4a of the fourth sub-optical unit O4 and an eighth length L14+L of a second surface of the eighth portion O4b of the fourth sub-optical unit O4 by the length difference L. That is, based on the direction perpendicular to the incident direction of the laser beam B, a width of the fourth bonded surface Sab4 may be the same as the length difference L on the fourth sub-optical unit O4.

The length difference L and the width of the fourth bonded surface Sab4 may be about 0.3 % to about 0.6 % of an entire length of the fourth sub-optical unit O4. For example, when the entire length of the fourth sub-optical unit O4 is about 2200 mm, the length difference L and the width of the fourth bonded surface Sab4 may be about 10 mm.

All lengths described above are lengths measured in the direction perpendicular to the direction in which the laser beam B is incident.

Also, the fourth bonded surface Sab4 of the fourth sub-optical unit O4 of the optical unit OP may form the fourth angle θ4 with the incident direction of the laser beam B, and based on the direction parallel to the incident direction of the laser beam B, a first width Wa of the seventh portion O4a of the fourth sub-optical unit O4 and a second width Wb of the eighth portion O4b of the fourth sub-optical unit O4 may be the same as each other on the fourth bonded surface Sab4.

Similarly, the fifth sub-optical unit O5 of the optical unit OP includes the ninth portion O5a and the tenth portion O5b bonded to each other on the fifth bonded surface Sab5, and a ninth length L05 of a first surface of the ninth portion O5a of the fifth sub-optical unit O5 and a tenth length L15 of a first surface tenth portion O5b of the fifth sub-optical unit O5 may be different, respectively, from a ninth length L05-L of a second surface of the ninth portion O5a of the fifth sub-optical unit O5 and a tenth length L15+L of a second surface of the tenth portion O5b of the fifth sub-optical unit O5 by the length difference L. That is, based on the direction perpendicular to the direction in which the laser beam B is incident, a width of the fifth bonded surface Sab5 may be equal to the length difference L on the fifth sub-optical unit O5.

The length difference L and the width of the fifth bonded surface Sab5 may be about 0.3 % to about 0.6 % of an entire length of the fifth sub-optical unit O5. For example, when the entire length of the fifth sub-optical unit O5 is about 2200 mm, the length difference L and the width of the fifth bonded surface Sab5 may be about 10 mm.

All lengths described above are lengths measured in the direction perpendicular to the direction in which the laser beam B is incident.

The fifth bonded surface Sab5 of the fifth sub-optical unit O5 of the optical unit OP may form the fifth angle θ5 with the incident direction of the laser beam B, and based on the direction parallel to the incident direction of the laser beam B, a first width Wa of the ninth portion O5a of the fifth sub-optical unit O5 and a second width Wb of the tenth portion O5b of the fifth sub-optical unit O5 may be the same as each other on the fifth bonded surface Sab5.

The first length L01 of the first portion O1a of the first sub-optical unit O1 of the optical unit OP, the third length L02 of the third portion O2a of the second sub-optical unit O2 of the optical unit OP, the fifth length L03 of the fifth portion O3a of the third sub-optical unit O3 of the optical unit OP, the seventh length L04 of the seventh portion O4a of the fourth sub-optical unit O4 of the optical unit OP, and the ninth length L05 of the ninth portion O5a of the fifth sub-optical unit O5 of the optical unit OP may be different from each other. Here, the first length L01, the third length L02, the fifth length L03, the seventh length L04, and the ninth length L05 may be lengths measured in the direction perpendicular to the incident direction of the laser beam B.

Similarly, the second length L11 of the second portion O1b of the first sub-optical unit O1 of the optical unit OP, the fourth length L12 of the fourth portion O2b of the second sub-optical unit O2 of the optical unit OP, the sixth length L13 of the sixth portion O3b of the third sub-optical unit O3 of the optical unit OP, the eighth length L14 of the eighth portion O4b of the fourth sub-optical unit O4 of the optical unit OP, and the tenth length L15 of the tenth portion O5b of the fifth sub-optical unit O5 of the optical unit OP may be different from each other. Here, the second length L11, the fourth length L12, the sixth length L13, the eighth length L14, and the tenth length L15 may be lengths measured in the direction perpendicular of the incident direction of the laser beam B.

The first portion O1a and the second portion O1b of the first sub-optical unit O1 of the optical unit OP may be bonded to each other through optical contact bonding or welding, the third portion O2a and the fourth portion O2b of the second sub-optical unit O2 of the optical unit OP may be bonded to each other through optical contact bonding or welding, the fifth portion O3a and the sixth portion O3b of the third sub-optical unit O3 of the optical unit OP may be bonded to each other through optical contact bonding or welding, the seventh portion O4a and the eighth portion O4b of the fourth sub-optical unit O4 of the optical unit OP may be bonded to each other through optical contact bonding or welding, and the ninth portion O5a and the tenth portion O5b of the fifth sub-optical unit O5 of the optical unit OP may be bonded to each other through optical contact bonding or welding.

Also, the first sub-optical unit O1, the second sub-optical unit O2, the third sub-optical unit O3, the fourth sub-optical unit O4, and the fifth sub-optical unit O5 of the optical unit OP may be sequentially disposed along the direction parallel to the incident direction of the laser beam B, and the first sub-optical unit O1, the second sub-optical unit O2, the third sub-optical unit O3, the fourth sub-optical unit O4, and the fifth sub-optical unit O5 of the optical unit OP may be bonded to each other through optical contact bonding or welding.

Based on the direction parallel to the incident direction of the laser beam B incident to the optical unit OP, the first bonded surface Sab1 of the first sub-optical unit O1 of the optical unit OP, the second bonded surface Sab2 of the second sub-optical unit O2 of the optical unit OP, the third bonded surface Sab3 of the third sub-optical unit O3 of the optical unit OP, the fourth bonded surface Sab4 of the fourth sub-optical unit O4 of the optical unit OP, and the fifth bonded surface Sab5 of the fifth sub-optical unit O5 of the optical unit OP are not disposed in a line with each other, but may be disposed to be offset from each other in a direction perpendicular to the incident direction of the laser beam B.

According to the embodiment illustrated in FIG. 9 and FIG. 10, it is described that the optical unit of the laser crystallization apparatus according to the embodiment includes five sub-optical units O1, O2, O3, O4, and O5, however it is not limited thereto, and the number of the plurality of sub-optical units may be changed.

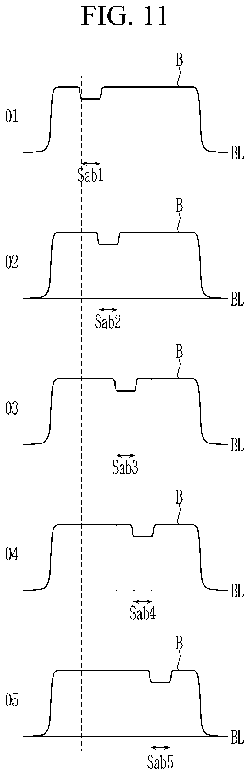

Now, a change in intensity of a laser beam passing through the optical unit of the laser crystallization apparatus according to an embodiment is described with reference to FIG. 11 along with FIG. 9 and FIG. 10. FIG. 11 is a graph conceptually illustrating changes in intensity of a laser beam passing through an optical unit of a laser crystallization apparatus according to another embodiment.

Referring to FIG. 11 along with FIG. 9 and FIG. 10, while the laser beam B passes through the first sub-optical unit O1, the second sub-optical unit O2, the third sub-optical unit O3, the fourth sub-optical unit O4, and the fifth sub-optical unit O5 of the optical unit OP, the intensity BL of the laser beam B may be reduced in the first bonded surface Sab1 of the first sub-optical unit O1 of the optical unit OP, the second bonded surface Sab2 of the second sub-optical unit O2 of the optical unit OP, the third bonded surface Sab3 of the third sub-optical unit O3 of the optical unit OP, the fourth bonded surface Sab4 of the fourth sub-optical unit O4 of the optical unit OP, and the fifth bonded surface Sab5 of the fifth sub-optical unit O5 of the optical unit OP.

As described with reference to FIG. 9 and FIG. 10, based on the direction parallel to the incident direction of the laser beam B incident to the optical unit OP of the laser crystallization apparatus according to the embodiment, because the first bonded surface Sab1 of the first sub-optical unit O1 of the optical unit OP, the second bonded surface Sab2 of the second sub-optical unit O2 of the optical unit OP, the third bonded surface Sab3 of the third sub-optical unit O3 of the optical unit OP, the fourth bonded surface Sab4 of the fourth sub-optical unit O4 of the optical unit OP, and the fifth bonded surface Sab5 of the fifth sub-optical unit O5 of the optical unit OP are not disposed in one line and are disposed to be offset from each other, the first bonded surface Sab1, the second bonded surface Sab2, the third bonded surface Sab3, the fourth bonded surface Sab4, and the fifth bonded surface Sab5, in which the intensity BL of the laser beam B is changed, do not overlap each other.

Accordingly, the change of the intensity BL of the laser beam B passing through the optical unit OP is not concentrated at a specific position, therefore a uniform laser beam B may be supplied substantially evenly to the substrate 14 according to the position of the bonded surfaces.

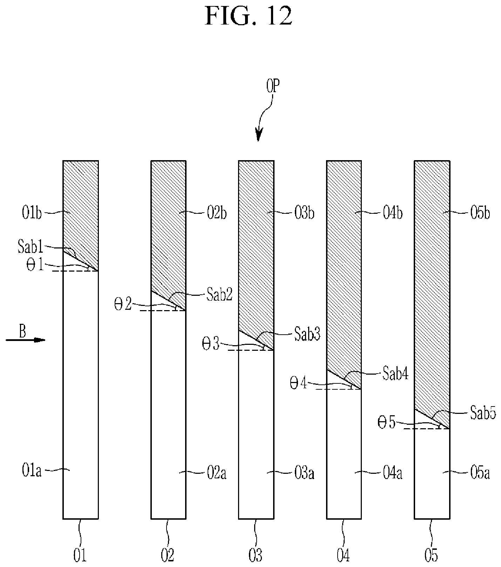

Next, the laser crystallization apparatus according to another embodiment is described with reference to FIG. 12. FIG. 12 is a view illustrating an example of an optical unit of a laser crystallization apparatus according to another embodiment.

As described herein, the laser crystallization apparatus according to the present embodiment includes a plurality of optical units OP1, M, OP2, W1, and W2, and at least one among the plurality of optical units OP1, M, OP2, W1, and W2 of the laser crystallization apparatus may have the structure of the optical unit OP illustrated in FIG. 12.

Referring to FIG. 12, the optical unit OP of the laser crystallization apparatus according to the present embodiment may include a plurality of sub-optical units O1, O2, O3, O4, and O5 separated from each other.

The first sub-optical unit O1 of the optical unit OP may include a first portion O1a and a second portion O1b bonded to each other, the second sub-optical unit O2 of the optical unit OP may include a third portion O2a and a fourth portion O2b bonded to each other, the third sub-optical unit O3 of the optical unit OP may include a fifth portion O3a and a sixth portion O3b bonded to each other, the fourth sub-optical unit O4 of the optical unit OP may include a seventh portion O4a and an eighth portion O4b bonded to each other, and the fifth sub-optical unit O5 of the optical unit OP may include a ninth portion O5a and a tenth portion O5b bonded to each other.

The first portion O1a and the second portion O1b of the first sub-optical unit O1 of the optical unit OP are bonded to each other on a first bonded surface Sab1, the third portion O2a and the fourth portion O2b of the second sub-optical unit O2 of the optical unit OP are bonded to each other on a second bonded surface Sab2, the fifth portion O3a and the sixth portion O3b of the third sub-optical unit O3 of the optical unit OP are bonded to each other on a third bonded surface Sab3, the seventh portion O4a and the eighth portion O4b of the fourth sub-optical unit O4 of the optical unit OP are bonded to each other on a fourth bonded surface Sab4, and the ninth portion O5a and the tenth portion O5b of the fifth sub-optical unit O5 of the optical unit OP are bonded to each other on a fifth bonded surface Sab5.

The first bonded surface Sab1 of the first sub-optical unit O1 of the optical unit OP, the second bonded surface Sab2 of the second sub-optical unit O2 of the optical unit OP, the third bonded surface Sab3 of the third sub-optical unit O3 of the optical unit OP, the fourth bonded surface Sab4 of the fourth sub-optical unit O4 of the optical unit OP, and the fifth bonded surface Sab5 of the fifth sub-optical unit O5 of the optical unit OP may respectively form a first angle θ1, a second angle θ2, a third angle θ3, a fourth angle θ4, and a fifth angle θ5 with the incident direction of the laser beam B incident to the optical unit OP. In addition, the first angle θ1, the second angle θ2, the third angle θ3, the fourth angle θ4, and the fifth angle θ5 may be the same as or different from each other.

Also, based on the direction parallel to the incident direction of the laser beam B incident to the optical unit OP, the first bonded surface Sab1 of the first sub-optical unit O1 of the optical unit OP, the second bonded surface Sab2 of the second sub-optical unit O2 of the optical unit OP, the third bonded surface Sab3 of the third sub-optical unit O3 of the optical unit OP, the fourth bonded surface Sab4 of the fourth sub-optical unit O4 of the optical unit OP, and the fifth bonded surface Sab5 of the fifth sub-optical unit O5 of the optical unit OP are not disposed in a line with each other, but may be disposed to be offset from each other in a direction perpendicular to the incident direction of the laser beam B.

According to the embodiment illustrated in FIG. 12, it is described that the optical unit of the laser crystallization apparatus according to an embodiment incudes five sub-optical units O1, O2, O3, O4, and O5, however it is not limited thereto, and the number of the plurality of sub-optical units may be changed.

Many characteristics of the optical units of the laser crystallization apparatus according to the embodiments described herein are applicable to all of the optical units of the laser crystallization apparatus according to the present embodiment.

As described herein, the laser crystallization apparatuses according to the embodiments include a plurality of optical units, and at least one among the plurality of optical units includes a first portion and a second portion bonded to each other, at least one among the plurality of optical units may include a plurality of sub-optical units including the first portion and the second portion bonded to each other, and the plurality of sub-optical units may be bonded to each other or separated from each other. In addition, the bonded surfaces of each of the plurality of sub-optical units may be disposed to be deviated or offset from each other without being disposed in one line along the direction parallel to the incident direction of the laser beam. Accordingly, it is possible to form the laser crystallization apparatus including the optical unit having a large size without increasing the manufacturing cost of the laser crystallization apparatus and without reducing the uniformity of the laser beam.

Although certain embodiments and implementations have been described herein, other embodiments and modifications will be apparent from this description. Accordingly, the inventive concepts are not limited to such embodiments, but rather to the broader scope of the appended claims.

## Claims

1. A laser crystallization apparatus comprising:
a light source unit (LS) configured to irradiate a laser beam (B); and
an optical unit (OP) to which the laser beam (B) is incident, in use, in an incident direction,
wherein the optical unit (OP) includes a first portion (Pa) and a second portion (Pb) bonded to each other to form a bonded surface (Sab), and
wherein a first width (Wa) of the first portion (Pa) and a second width (Wb) of the second portion (Pb) are the same as each other at the bonded surface (Sab) based on a direction parallel to the incident direction of the laser beam (B);
wherein the optical unit (OP) comprises a plurality of sub-optical units (O1, O2, O3, O4, O5), **characterised in that**
each of the plurality of sub-optical units (O1, O2, O3, O4, O5) includes a first portion (Pa) and a second portion (Pb) bonded to each other to form a bonded surface (Sab), and
wherein the plurality of sub-optical units (O1, O2, O3, O4, O5) are sequentially arranged in the direction parallel to the incident direction of the laser beam (B); and
wherein the plurality of sub-optical units (O1, O2, O3, O4, O5) include a first sub-optical unit (O1) and a second sub-optical unit (O2), and
a length (L01) of a first portion (O1a) of the first sub-optical unit (O1) is different from a length (L02) of a first portion (O2a) of the second sub-optical unit (O2); and
wherein the bonded surface (Sab1) of the first sub-optical unit (O1) and the bonded surface (Sab2) of the second sub-optical unit (O2) are disposed parallel to each other and offset from each other in the direction parallel to the incident direction of the laser beam (B).

2. The laser crystallization apparatus of claim 1, wherein
in a direction perpendicular to the incident direction of the laser beam (B), a first length (La) of the first portion (Pa) and a second length (Lb) of the second portion (Pb) are different from each other.

3. The laser crystallization apparatus of claim 1 or claim 2, wherein
the first portion (Pa) and the second portion (Pb) are bonded by optical contact bonding or welding.

4. The laser crystallization apparatus of any preceding claim, wherein
the bonded surface (Sab) is parallel to the incident direction of the laser beam (B).

5. The laser crystallization apparatus of any of claims 1 to 3, wherein
the bonded surface (Sab) is inclined to form a predetermined angle with the incident direction of the laser beam (B).

6. The laser crystallization apparatus of claim 5, wherein
in a direction perpendicular to the incident direction of the laser beam (B), a width of the bonded surface (Sab) is about 0.3 % to about 0.6 % of a length of the optical unit (OP).

7. The laser crystallization apparatus of any preceding claim, wherein
a length of the optical unit (OP) is about 2000 mm to about 2500 mm in a direction perpendicular to the incident direction of the laser beam (B).

8. The laser crystallization apparatus of claim 1, wherein
the bonded surface (Sab1) of the first sub-optical unit (O1) and the bonded surface (Sab2) of the second sub-optical unit (O2) are parallel to the incident direction of the laser beam (B).

9. The laser crystallization apparatus of claim 1, wherein
the bonded surface (Sab1) of the first sub-optical unit (O1) and the bonded surface (Sab2) of the second sub-optical unit (O2) are inclined to form a predetermined angle with the incident direction of the laser beam (B).

10. The laser crystallization apparatus of claim 1, wherein
in a direction perpendicular to the incident direction of the laser beam (B), a width of the bonded surface (Sab1) of the first sub-optical unit (O1) is about 0.3 % to about 0.6 % of a length of the first sub-optical unit (O1), and, optionally, the length of the first sub-optical unit (O1) is about 2000 mm to about 2500 mm.

11. The laser crystallization apparatus of any preceding claim, wherein
the plurality of sub-optical units (O1, O2, O3, O4, O5) are bonded together along the incident direction of the laser beam (B).

12. The laser crystallization apparatus of any preceding claim, wherein
the plurality of sub-optical units (O1, O2, O3, O4, O5) are separated from each other along the incident direction of the laser beam (B).

## Patentansprüche

1. Vorrichtung zur Laserkristallisation, umfassend:
eine Lichtquelleneinheit (LS), die dafür konfiguriert ist, einen Laserstrahl (B) auszustrahlen; und
eine optische Einheit (OP), auf die der Laserstrahl (B) bei Verwendung in einer Einfallsrichtung einfällt,
wobei die optische Einheit (OP) einen ersten Abschnitt (Pa) und einen zweiten Abschnitt (Pb) einschließt, die miteinander verbunden sind, um eine verbundene Oberfläche (Sab) auszubilden, und
wobei eine erste Breite (Wa) des ersten Abschnitts (Pa) und eine zweite Breite (Wb) des zweiten Abschnitts (Pb) an der verbundenen Oberfläche (Sab) auf der Grundlage einer Richtung parallel zur Einfallsrichtung des Laserstrahls (B) gleich sind;
wobei die optische Einheit (OP) eine Vielzahl von optischen Untereinheiten (O1, O2, O3, O4, O5) umfasst, **dadurch gekennzeichnet, dass**:
jede der Vielzahl von optischen Untereinheiten (O1, O2, O3, O4, O5) einen ersten Abschnitt (Pa) und einen zweiten Abschnitt (Pb) einschließt, die miteinander verbunden sind, um eine verbundene Oberfläche (Sab) auszubilden, und
wobei die Vielzahl von optischen Untereinheiten (O1, O2, O3, O4, O5) der Reihe nach in der Richtung parallel zur Einfallsrichtung des Laserstrahls (B) angeordnet sind; und
wobei die Vielzahl von optischen Untereinheiten (O1, O2, O3, O4, O5) eine erste optische Untereinheit (O1) und eine zweite optische Untereinheit (O2) einschließt, und
eine Länge (L01) eines ersten Abschnitts (O1a) der ersten optischen Untereinheit (O1) sich von einer Länge (L02) eines ersten Abschnitts (O2a) der zweiten optischen Untereinheit (O2) unterscheidet; und
wobei die verbundene Oberfläche (Sab1) der ersten optischen Untereinheit (O1) und die verbundene Oberfläche (Sab2) der zweiten optischen Untereinheit (O2) parallel zueinander angeordnet und in der Richtung parallel zur Einfallsrichtung des Laserstrahls (B) gegeneinander versetzt sind.

2. Vorrichtung zur Laserkristallisation nach Anspruch 1, wobei
eine erste Länge (La) des ersten Abschnitts (Pa) und eine zweite Länge (Lb) des zweiten Abschnitts (Pb) sich in einer Richtung senkrecht zur Einfallsrichtung des Laserstrahls (B) voneinander unterscheiden.

3. Vorrichtung zur Laserkristallisation nach Anspruch 1 oder 2, wobei:
der erste Abschnitt (Pa) und der zweite Abschnitt (Pb) durch optisches Kontaktbonden oder -schweißen verbunden sind.

4. Vorrichtung zur Laserkristallisation nach einem der vorhergehenden Ansprüche, wobei:
die verbundene Oberfläche (Sab) parallel zur Einfallsrichtung des Laserstrahls (B) ist.

5. Vorrichtung zur Laserkristallisation nach einem der Ansprüche 1 bis 3, wobei:
die verbundene Oberfläche (Sab) geneigt ist, um einen vorbestimmten Winkel mit der Einfallsrichtung des Laserstrahls (B) auszubilden.

6. Vorrichtung zur Laserkristallisation nach Anspruch 5, wobei:
eine Breite der verbundenen Oberfläche (Sab) in einer Richtung senkrecht zur Einfallsrichtung des Laserstrahls (B) etwa 0,3 % bis etwa 0,6 % einer Länge der optischen Einheit (OP) beträgt.

7. Vorrichtung zur Laserkristallisation nach einem der vorhergehenden Ansprüche, wobei:
eine Länge der optischen Einheit (OP) in einer Richtung senkrecht zur Einfallsrichtung des Laserstrahls (B) etwa 2 000 mm bis etwa 2 500 mm beträgt.

8. Vorrichtung zur Laserkristallisation nach Anspruch 1, wobei:
die verbundene Oberfläche (Sab1) der ersten optischen Untereinheit (O1) und die verbundene Oberfläche (Sab2) der zweiten optischen Untereinheit (O2) parallel zur Einfallsrichtung des Laserstrahls (B) sind.

9. Vorrichtung zur Laserkristallisation nach Anspruch 1, wobei:
die verbundene Oberfläche (Sab1) der ersten optischen Untereinheit (O1) und die verbundene Oberfläche (Sab2) der zweiten optischen Untereinheit (O2) geneigt sind, um einen vorbestimmten Winkel mit der Einfallsrichtung des Laserstrahls (B) auszubilden.

10. Vorrichtung zur Laserkristallisation nach Anspruch 1, wobei:
eine Breite der verbundenen Oberfläche (Sab1) der ersten optischen Untereinheit (O1) in einer Richtung senkrecht zur Einfallsrichtung des Laserstrahls (B) etwa 0,3 % bis etwa 0,6 % einer Länge der ersten optischen Untereinheit (O1) beträgt, und optional die Länge der ersten optischen Untereinheit (O1) etwa 2 000 mm bis etwa 2 500 mm beträgt.

11. Vorrichtung zur Laserkristallisation nach einem der vorhergehenden Ansprüche, wobei:
die Vielzahl von optischen Untereinheiten (O1, O2, O3, O4, O5) entlang der Einfallsrichtung des Laserstrahls (B) miteinander verbunden sind.

12. Vorrichtung zur Laserkristallisation nach einem der vorhergehenden Ansprüche, wobei:
die Vielzahl von optischen Untereinheiten (O1, O2, O3, O4, O5) entlang der Einfallsrichtung des Laserstrahls (B) voneinander getrennt sind.

## Revendications

1. Appareil de cristallisation au laser comprenant :
une unité de source de lumière (LS) configurée pour irradier un faisceau laser (B) ; et
une unité optique (OP) sur laquelle le faisceau laser (B) arrive en incidence, en utilisation, dans une direction d'incidence,
dans lequel l'unité optique (OP) inclut une première partie (Pa) et une seconde partie (Pb) liées l'une à l'autre pour former une surface liée (Sab), et
dans lequel une première largeur (Wa) de la première partie (Pa) et une seconde largeur (Wb) de la seconde partie (Pb) sont identiques au niveau de la surface liée (Sab) sur la base d'une direction parallèle à la direction d'incidence du faisceau laser (B) ;
dans lequel l'unité optique (OP) comprend une pluralité de sous-unités optiques (O1, O2, O3, O4, O5), **caractérisé en ce que**
chacune de la pluralité de sous-unités optiques (O1, O2, O3, O4, O5) inclut une première partie (Pa) et une seconde partie (Pb) liées l'une à l'autre pour former une surface liée (Sab), et
dans lequel la pluralité de sous-unités optiques (O1, O2, O3, O4, O5) sont agencées séquentiellement dans la direction parallèle à la direction d'incidence du faisceau laser (B) ; et
dans lequel la pluralité de sous-unités optiques (O1, O2, O3, O4, O5) incluent une première sous-unité optique (O1) et une deuxième sous-unité optique (O2), et
une longueur (L01) d'une première partie (O1a) de la première sous-unité optique (O1) est différente d'une longueur (L02) d'une première partie (O2a) de la deuxième sous-unité optique (O2) ; et
dans lequel la surface liée (Sab1) de la première sous-unité optique (O1) et la surface liée (Sab2) de la deuxième sous-unité optique (O2) sont disposées parallèlement l'une à l'autre et sont décalées l'une de l'autre dans la direction parallèle à la direction d'incidence du faisceau laser (B).

2. Appareil de cristallisation au laser selon la revendication 1, dans lequel
dans une direction perpendiculaire à la direction d'incidence du faisceau laser (B), une première longueur (La) de la première partie (Pa) et une seconde longueur (Lb) de la seconde partie (Pb) sont différentes l'une de l'autre.

3. Appareil de cristallisation au laser selon la revendication 1 ou la revendication 2, dans lequel
la première partie (Pa) et la seconde partie (Pb) sont liées par liaison ou soudage par contact optique.

4. Appareil de cristallisation au laser selon l'une quelconque des revendications précédentes, dans lequel
la surface liée (Sab) est parallèle à la direction d'incidence du faisceau laser (B).

5. Appareil de cristallisation au laser selon l'une quelconque des revendications 1 à 3, dans lequel
la surface liée (Sab) est inclinée pour former un angle prédéterminé avec la direction d'incidence du faisceau laser (B).

6. Appareil de cristallisation au laser selon la revendication 5, dans lequel
dans une direction perpendiculaire à la direction d'incidence du faisceau laser (B), une largeur de la surface liée (Sab) est égale à environ 0,3 % à environ 0,6 % d'une longueur de l'unité optique (OP).

7. Appareil de cristallisation au laser selon l'une quelconque des revendications précédentes, dans lequel
une longueur de l'unité optique (OP) est égale à environ 2 000 mm à environ 2 500 mm dans une direction perpendiculaire à la direction d'incidence du faisceau laser (B).

8. Appareil de cristallisation au laser selon la revendication 1, dans lequel
la surface liée (Sab1) de la première sous-unité optique (O1) et la surface liée (Sab2) de la deuxième sous-unité optique (O2) sont parallèles à la direction d'incidence du faisceau laser (B).

9. Appareil de cristallisation au laser selon la revendication 1, dans lequel
la surface liée (Sab1) de la première sous-unité optique (O1) et la surface liée (Sab2) de la deuxième sous-unité optique (O2) sont inclinées pour former un angle prédéterminé avec la direction d'incidence du faisceau laser (B).

10. Appareil de cristallisation au laser selon la revendication 1, dans lequel
dans une direction perpendiculaire à la direction d'incidence du faisceau laser (B), une largeur de la surface liée (Sab1) de la première sous-unité optique (O1) est égale à environ 0,3 % à environ 0,6 % d'une longueur de la première sous-unité optique (O1) et optionnellement, la longueur de la première sous-unité optique (O1) est égale à environ 2 000 mm à environ 2 500 mm.

11. Appareil de cristallisation au laser selon l'une quelconque des revendications précédentes, dans lequel
la pluralité de sous-unités optiques (O1, O2, O3, O4, O5) sont liées ensemble suivant la direction d'incidence du faisceau laser (B).

12. Appareil de cristallisation au laser selon l'une quelconque des revendications précédentes, dans lequel
la pluralité de sous-unités optiques (O1, O2, O3, O4, O5) sont séparées les unes des autres suivant la direction d'incidence du faisceau laser (B).
